(19) Europäisches Patentamt
European Patent Office
Office européen des brevets

(11) Veröffentlichungsnummer: **0 201 766 B1**

(12) **EUROPÄISCHE PATENTSCHRIFT**

(45) Veröffentlichungstag der Patentschrift: **18.12.91**

(51) Int. Cl.⁵: **H03H 9/02, H03H 9/145**

(21) Anmeldenummer: **86105543.2**

(22) Anmeldetag: **22.04.86**

(54) **Mit akustischen Wellen arbeitendes elektrisches Filter.**

(30) Priorität: **13.05.85 DE 3517254**

(43) Veröffentlichungstag der Anmeldung:
**20.11.86 Patentblatt 86/47**

(45) Bekanntmachung des Hinweises auf die
Patenterteilung:
**18.12.91 Patentblatt 91/51**

(84) Benannte Vertragsstaaten:
**AT DE FR GB IT NL**

(56) Entgegenhaltungen:
**FR-A- 2 313 811**
**GB-A- 2 047 034**
**US-A- 3 573 673**

**PATENT ABSTRACTS OF JAPAN, Band 6, Nr.
64 (E-103)[942], 23. April 1982; & JP-A-57 4613
(MURATA SEISAKUSHO K.K.) 11-01-1982**

(73) Patentinhaber: **SIEMENS AKTIENGESELL-
SCHAFT**
**Wittelsbacherplatz 2**
**W-8000 München 2(DE)**

(72) Erfinder: **Zibis, Peter, Dipl.-Ing.**
**Kafkastrasse 14**
**W-8000 München 83(DE)**
Erfinder: **Riha, Gerd, Dr.-Ing.**
**Lerchenauerstrasse 19**
**W-8000 München 40(DE)**
Erfinder: **Veith, Richard, Dipl.-Phys.**
**Habichtstrasse 56**
**W-8025 Unterhaching(DE)**

## Beschreibung

Die vorliegende Erfindung bezieht sich auf ein elektrisches Filter nach dem Oberbegriff des Patentanspruches 1.

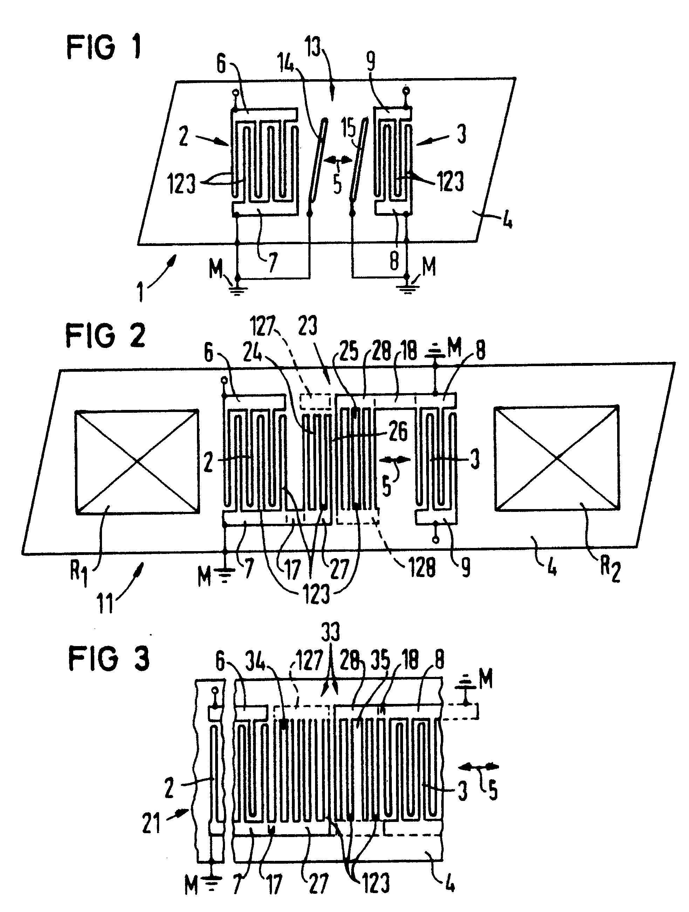

Aus Proc. of the IEEE, Bd. 67 (1969), S. 147 - 157, Fig. 3 ist ein akustisches Wellenfilter als Resonatorfilter bekannt, das auf der Oberfläche des Substrats direkt nebeneinanderliegend angeordnet einen Eingangswandler und einen Ausgangswandler hat. Trotz entsprechender Polung läßt sich bei einem solchen Filter ein störendes Maß an Übersprechen zwischen Eingang und Ausgang feststellen.

Zur Abschirmung zwischen Eingangswandler und Ausgangswandler hat man deshalb, wie aus "1982 Ultrasonics" Symposium 1982 IEEE, S. 284 - 289 bekannt, solche wie dort in Figur 6 gezeigte Anordnungen vorgesehen. Bei einer solchen abschirmenden Anordnung handelt es sich im wesentlichen darum, daß eine quer zur Hauptfortpflanzungsachse der im Filter laufenden Wellen ausgerichtete, balkenförmige Struktur als Oberflächenbelegung des Substrats vorgesehen ist, die auf Masse als Bezugspotential gelegt ist. Diese auf Masse liegende, einen breiten Streifen bildende Oberflächenbelegung ist zwischen Eingangswandler und Ausgangswandler positioniert und bewirkt an sich eine gute Abschirmung. Bei entsprechend hohen Frequenzen machen sich jedoch bereits die Zuleitungsinduktivitäten des Anschlusses dieser Abschirmung an das Bezugspotential in der Weise nachteilig bemerkbar, daß undefinierte elektrische Potentiale auf dieser abschirmenden Belegung auftreten und entsprechende Störungen zwischen Eingang und Ausgang verursachen.

Es sei des weiteren noch auf Ultrasonics Symposium 1979 IEEE, S. 841 - 844 hingewiesen.

Als eine den Oberbegriff des Patentanspruches 1 betreffende Maßnahme zur Verringerung des Übersprechens zwischen benachbarten Wandlern des Eingangs und des Ausgangs sind in der US-A-3 573 673, Figur 3 zusätzliche Belegungen der Substratoberfläche gezeigt, die streifenförmig ausgebildet und schräg zur Achse der Hauptfortpflanzung der Welle ausgerichtet sind. Diese streifenförmigen Belegungen sind hinsichtlich ihres Potentials mit dem Massepotential des jeweils benachbarten Wandlers durch eine Leitung elektrisch miteinander verbunden. Die Figur 1 zeigt das Prinzip eines solchen jeweils einzelnen, abschirmenden Streifens, der zwar hinsichtlich seiner Form den streifenförmigen Belegungen entspricht, aus denen die Wandlerstrukturen bestehen, jedoch ist diese streifenförmige Belegung absichtlich in einem erheblichen Winkel schräg zur Achse der Hauptfortpflanzung der Welle zwischen dem Eingangswandler und dem Ausgangswandler ausgerichtet. Es sollen an einer solchen abschirmenden, streifenförmigen Belegung auftretende Wellenreflexionen aus der Achse der Wellenfortpflanzung herausgelenkt werden.

Aufgabe der vorliegenden Erfindung ist es, abschirmende Strukturen anzugeben, die in Einheit mit einer weiteren Funktion im Filter bzw. zur Herstellung des Filters dienen, das heißt, daß nicht notwendigerweise zusätzliche Strukturen in ein Filter einzufügen sind.

Diese Aufgabe wird mit einem Filter mit den Merkmalen des Patentanspruches 1 gelöst und weitere Ausgestaltungen und Weiterbildungen gehen aus den Unteransprüchen hervor, wobei insbesondere auf die Ausgestaltungen nach den Ansprüchen 3 und 4 hingewiesen sei.

Bei der Erfindung sind Teilstrukturen aus miteinander elektrisch verbundenen, streifenförmigen Belegungen vorgesehen, die den in den Digitalstrukturen des Filters vorhandenen streifenförmigen Belegungen nach Form und Ausrichtung gleichartig sind. Vorzugsweise haben die aus einer Anzahl derartiger streifenförmiger Belegungen bestehenden Teilstrukturen jeweils wenigstens eine, vorzugsweise an beiden Enden je eine Sammelschiene, von denen diese eine bzw. die eine der Sammelschienen über eine Verbindungsbelegung mit der auf Bezugspotential liegenden, bereits erwähnten Sammelschiene der benachbarten Wandlerstruktur verbunden ist. Von besonderem Vorteil ist die Erfindung bei einem Filter anzuwenden, das zwischen Eingangswandler und Ausgangswandler eine Koppelstruktur hat, wie z.B. nach Figur 7, in Proc. of the IEEE, Bd. 67 (1979), S. 150. Eine andere besonders bevorzugte Anwendung der Erfindung bietet sich bei einem mit akustischen Wellen arbeitenden Filter nach der älteren nicht vorveröffentlichten EP-A 0 189 106, bei der sich bei einer Anordnung nach der dort beigefügten Figur zwischen dem Eingangswandler und dem Ausgangswandler eine weitere Struktur befindet. Diese ist ein Kollektiv aus streifenförmigen, elektrisch leitenden Belegungen, die den streifenförmigen Belegungen der Digitalstrukturen des Filters entsprechen und die so positioniert und ausgebildet sind, daß sie insgesamt reflexionsfrei sind.

Sie sind bei dem Filter nach dieser EP-A- 0 189 106 dazu vorgesehen, während der fotolithografischen Herstellung des Filters zur Egalisierung der Belichtung zu dienen.

Weitere Erläuterungen zur Erfindung gehen aus der nachfolgenden, anhand der beigefügten Figurenbeschreibung bevorzugter Ausführungsbeispiele hervor.

Figur 1 zeigt ein Filter nach dem Stand der Technik mit einer einfachen Abschirmung.

Figur 2 zeigt eine erste Ausführungsform der Erfindung, bei der eine ohnehin vorgesehene Koppelstruktur als nach der Erfindung außerdem abschirmend ausgebildet ist.

Figuren 3 bis 5 zeigen Ausschnitte weiterer Ausführungsformen, deren übrige Anteile z.B. der Figur 2 entsprechen und deren erfindungsgemäß ausgebildete abschirmende Struktur gleichzeitig die Funktion nach der EP-A- 0 189 106 erfüllt bzw. eine Führungsstruktur ist.

Figur 1 zeigt ein Filter 1 mit zwei Interdigitalstrukturen 2 und 3, von denen die eine ein Eingangswandler und die andere ein Ausgangswandler ist. Diese Interdigitalstrukturen 2, 3 sind in üblicher Weise aufgebaut und können verschiedenste spezielle Ausgestaltungen haben. Wesentliches Merkmal derselben ist, daß sie Elektrodenfinger aus elektrisch leitfähigen (Metall-)Belegungen der Oberfläche des piezoelektrischen Substrats 4 besitzen. Diese interdigital angeordneten streifenförmigen Belegungen der Fingerelektroden sind in Richtung der Hauptfortpflanzungsachse 5 der in diesem Filter erzeugten Wellen aufeinanderfolgend abwechselnd mit einer Sammelschiene 6 bzw. 7 respektive mit einer Sammelschiene 8 bzw. 9 der einen Wandlerstruktur 2 bzw. der anderen Wandlerstruktur 3 verbunden. Für den vorgesehenen unsymmetrischen Betrieb des Filters sind z.B. die Sammelschienen 7 und 8 auf Bezugspotential, insbesondere Masse gelegt. Die anderen Sammelschienen 6 und 9 sind die sog. heißen Anschlußenden des Filters 1. Mit 13 ist eine im wesentlichen quer zur Hauptfortpflanzungsachse 5 ausgerichtete, Struktur einer Oberflächenbelegung des Substrats 4 bezeichnet. Deren beide Teilstrukturen 14 und 15 sind durch einen ebenfalls quer zu dieser Achse 5 ausgerichteten Zwischenraum elektrisch voneinander getrennt, der keine elektrisch leitende Oberflächenbelegung des Substrats 4 aufweist. Die in der Figur 1 angegebene Schrägstellung der Teilstrukturen 14 und 15 dient z.B. dazu, an den quer zur Achse 5 verlaufenden Kanten reflektierte Wellenanteile schräggerichtet herauszureflektieren.

Wie aus der Figur 1 ersichtlich, sind Leitungen vorgesehen, mit denen die Sammelschiene 7 die Sammelschiene 8 an das Bezugspotential M angeschlossen, sind. Diese Teilstrukturen 14 und 15 können so als Abschirmungen wirken.

Figur 2 zeigt eine Ausführungsform der Erfindung, wobei zur Figur 1 bereits beschriebene Einzelheiten in Figur 2 dieselben Bezugszeichen mit derselben Bedeutung haben. Ein wesentlicher Unterschied der erfindungsgemässen Ausführungsform 11 nach Figur 2 gegenüber derjenigen nach Figur 1 ist die Verwendung einer aus vielen streifenförmigen Oberflächenbelegungen bestehenden Koppelstruktur 23, die aus einer in Richtung der Achse 5 nebeneinander, aufeinanderfolgend angeordneten Anzahl streifenförmiger Oberflächenbelegungen 123 besteht. Eine der Ausführungsform nach Figur 2 zugrundeliegende Anordnung mit Koppelstruktur zwischen zwei Interdigitalwandlern 2, 3 ist z.B. aus den obengenannten Druckschriften Ultrasonics Symposium (1979), S. 841, Fig. 1 und Proceedings of the IEEE, Bd. 67 (1979), S. 150, unterste Zeile in Fig. 7 bekannt. Bei einer solchen Koppelstruktur entsprechen die streifenförmigen Belegungen 123 in ihrer Ausgestaltung und ihren Abmessungen im Regelfall den Fingerelektroden der Wandlerstrukturen 2, 3, jedoch ist für eine Solche Koppelstruktur keine interdigitale Anordnung mit dazu notwendigerweise erforderlichen Sammelschienen vorgesehen. Eine solche Koppelstruktur bewirkt genau genommen eine graduelle Entkopplung.

Bei der Ausführungsform der Figur 2 der Erfindung ist im Sinne der Erfindung eine solche Koppelstruktur zugleich auch als abschirmende Struktur (entsprechend der Struktur 14, 15 der Figur 1) benutzt und entsprechend speziell ausgestaltet. Diese Koppelstruktur 23 ist bei der Erfindung jedoch in (mindestens) zwei Teilstrukturen 24 und 25 aufgeteilt, die durch einen freien Streifen 26 voneinander getrennt sind. Dieser ist z.B. nicht breiter als die Abstände der streifenförmigen Belegungen 123 innerhalb der einzelnen Koppelstrukturen 24, 25 bzw. der Wandler 2, 3 ist. Es kann aber auch ein breiterer freier Streifen 26 vorgesehen sein, was einer Weglassung dort ansonsten in einer bekannten Struktur vorhandener streifenförmiger Belegungen (wie 123) der bekannten Koppelstruktur gleichkommt.

Eine besondere Ausgestaltungsmaßnahme ist, daß die Teilstruktur 24 wenigstens eine Sammelschiene 27 hat. Entsprechendes gilt für die Teilstruktur 25 mit ihrer Sammelschiene 28. Die Sammelschienen 27 bzw. 28 dienen dazu, die streifenförmigen Belegungen 123 der einen Teilstruktur 24 bzw. der anderen Teilstruktur 25, wie aus Figur 2 ersichtlich, elektrisch untereinander zu verbinden. Erfindungsgemäß sind bei der Ausführungsform nach Figur 2 Verbindungsbelegungen 17 und 18 vorgesehen, die diese Teilstrukturen 24 und 25 jeweils mit der auf Bezugspotential liegenden Sammelschiene 7 bzw. 8 der Wandlerstruktur 2 bzw. 3 verbindet.

Bei der Ausführungsform nach Figur 2 ist ein zu Störungen führender elektrischer Stromfluß und das Entstehen einer entsprechenden Störspannung zwischen den Wandlern 2 und 3 ausgeschlossen.

Wie dies der Figur 2 zu entnehmen ist, können noch zusätzlich Sammelschienen oder diesen in ihrer allgemeinen Form entsprechende Oberflächenbelegungen 127 und 128 vorgesehen sein. Die Oberflächenbelegung 127 kann ebenfalls mit den streifenförmigen Belegungen 123 der Teilstruktur 24 verbunden sein. Eine zwingende Notwendigkeit für diese Verbindungen besteht jedoch nicht. Dies gilt auch für die derartige zusätzliche Oberflächenbelegung 128 und bei der Teilstruktur 25 ist diese zweite alternative Möglichkeit mit elektrischen Verbindungen dargestellt. Insbesondere dienen diese zusätzlichen, Sammelschienen entsprechenden Oberflächenbelegungen 127 und 128 dazu, eine Symmetrie des Vorhandenseins und der Anordnung von Oberflächenbelegungen zu erreichen.

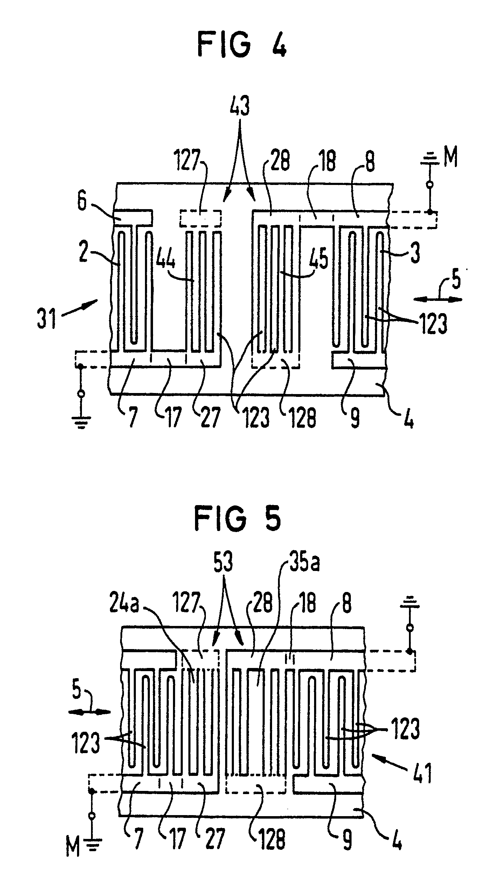

Als Koppelstruktur ist diese aus den Teilstrukturen 24 und 25 insgesamt bestehende Struktur 23 mit den streifenförmigen Belegungen 123 reflektierend wirksam. Diese Reflexionswirkung bezieht sich auf die in dem Filter erzeugten bzw. in Richtung der Hauptfortpflanzungsachse 5 verlaufenden akustischen Wellen. Das Ausführungsbeispiel der Figur 5 enthält zusätzlich noch (wie auch im hierzu obengenannten Stand der Technik) Reflektorstrukturen R1 und R2. Aufgrund der Reflexionswirkung der Koppelstruktur 23 werden die beiden (in Figur 2) rechts und links bezogen auf die Struktur 23 liegenden Anteile dieses Filters 21 der Figur 2 wellenakustisch und aufgrund der piezoelektrischen Eigenschaft des Substrats 4 auch elektrisch miteinander gekoppelt.

Ein erfindungsgemäßes Filter kann auch mit der Figur 2 entsprechenden Teilstrukturen 24 und 25 als Abschirmungen zwischen den Wandlerstrukturen 2 und 3 ausgeführt sein, ohne daß diese Teilstrukturen 24 und 25 zusammen als Koppelstruktur wirksam sind bzw. wirken müssen. In der obengenannten EP-A 0 189 106 ist die Verwendung von zusätzlichen, aus streifenförmigen Oberflächenbelegungen bestehenden Strukturen beschrieben. In der in dieser Druckschrift angegebenen Ausführungsform ist eine solche Struktur mit 100 bezeichnet, die sich zwischen den beiden Wandlerstrukturen des Filters befindet.

Sinn dieser zusätzlichen Struktur ist dort, eine Egalisierung für bzw. im Verlauf des fotolitografischen Herstellungsverfahrens der streifenförmigen Belegungen dieser Strukturen zu erreichen. Aus diesem Grunde sind dort die streifenförmigen Belegungen einer solchen zusätzlichen Struktur entsprechend den streifenförmigen Oberflächenbelegungen den notwendigen Digitalstrukturen (Wandlerstrukturen und Reflektorstrukturen) des Filters dieser älteren Anmeldung ausgebildet. Es ist dort auch die Alternative beschrieben, eine solche zusätzliche Struktur mit Sammelschienen (dort mit 106 bezeichnet) zu versehen. Entscheidend bei dem Filter dieser Druckschrift ist, daß diese dort zwischen den beiden Interdigitalwandlern angeordnete zusätzliche Struktur für die akustische Welle reflexionsfrei ausgestaltet bzw. bemessen ist. Dies steht im Gegensatz zur Koppelstruktur 23 der Figur 2 der vorliegenden Erfindung. Wie man eine solche (zusätzliche) Struktur reflexionsfrei ausbildet ist soweit nicht schon anderweitig bekannt, in dieser Druckschrift ausführlich beschrieben. Insbesondere ist dies durch (vergleichsweise zu den notwendigen Strukturen des Filters) abweichende Bemessung der Abstände der streifenförmigen Belegungen oder durch Viertellängen der effektiven Wellenlänge der akustischen Welle bemessene Abstandssprünge (wie bei der Struktur 200) zu erreichen.

In Figur 3 der vorliegenden Erfindungsbeschreibung ist diese weitere Ausführungsform 21 der Erfindung lediglich im Ausschnitt dargestellt. Die Struktur 33 ist eine insgesamt reflexionsfreie Struktur und besteht aus den Teilstrukturen 34 und 35. Die streifenförmigen Belegungen 123 der Strukturen 34 und 35 haben jedoch entsprechend der älteren Anmeldung gewählte Abstände. Die Teilstruktur 34 hat (Mitten-)Abstände der einzelnen streifenförmigen Belegungen 123 voneinander, die um ein Maß abweichend von den (Mitten-)Abständen der streifenförmigen Belegungen der notwendigen Digitalstrukturen des Filters sind, nämlich abweichend von denjenigen (Mitten-)Abständen sind, die die Mittenfrequenz bzw. die effektive Wellenlänge der akustischen Welle des betreffenden Filters bestimmen. Das Maß dieser Abweichung ist so gewählt, daß die Frequenz der ersten Nullstelle der interdigitalen Reflexionen der streifenförmigen Belegungen dieser Teilstruktur 34 mit der (vorgegebenen) Mittenfrequenz des betreffenden Filters zusammenfällt.

Die Teilstruktur 35 kann in der gleichen Weise wie die Teilstruktur 34 ausgebildet sein. Die Darstellung der Figur 3 zeigt jedoch eine zweite Alternative einer in dem Filter reflexionsfreien Struktur, nämlich mit einer solchen Anordnung der streifenförmigen Belegungen, bei denen einzelne streifenförmige Belegungen 123 der Teilstruktur 35, vorzugsweise gruppenweise, so angeordnet sind, daß die (Mitten-)Abstände einzelner streifenförmiger Belegungen 123 bzw. der streifenförmigen Belegungen einzelner Gruppen um eine (bzw. ein ungradzahliges Vielfaches einer) Viertelwellenlänge verschieden sind, von den die Mittenfrequenz des Filters bestimmenden Abständen der streifenförmigen Belegungen der Strukturen 2 bzw. 3.

Im Sinne der EP-A- 0 189 106 ist vorzugsweise der Abstand zwischen der Struktur 2 und der Teilstruktur 34 bzw. der Abstand zwischen der Struktur 3 und der Teilstruktur 35 bis auf den Abstand der streifenförmigen Belegungen 123 bzw. der Fingerelektroden der Wandler 2, 3 verringert, so daß die Verbindungsbelegungen 17, 18 entsprechend kurz ist.

Weitere Einzelheiten eines Filters nach Figur 3 entsprechen denen eines Filters nach Figur 2. Entsprechendes gilt für die übereinstimmenden Bezugszeichen.

Für SBAW- und für SSBW-Akustikwellen, die jeweils eine spezielle Art oberflächennah in einem Substrat verlaufender akustischer Wellen sind, und die im Sinne der vorliegenden Erfindung unter den hier verwendeten Begriff der Oberflächenwellen fallen, ist aus "1979 Ultrasonics Symposium", S. 783 bis 785 eine Anordnung bekannt, bei der zwischen einer Eingangs-Wandlerstruktur und einer Ausgangs-Wandlerstruktur, die auf der Oberfläche des Substrats einen Abstand voneinander haben, eine zusätzliche "Führungs-"Struktur * angeordnet ist. Figur 4 zeigt in einer Ausschnittsdarstellung eine solche Anordnung 31. Diese zwischen den Wandlerstrukturen dort vorgesehene Führungsstruktur dient dazu, die zwischen diesen beiden Wandlerstrukturen laufende SBAW-Welle daran zu hindern, den oberflächennahen Bereich des Substrats zu verlassen, d.h. in das Innere des Substratkörpers wegzutauchen. Für eine solche Struktur genügt es, streifenförmige Belegungen vorzusehen, die jedoch hinsichtlich der Resonanz der durch sie gebildeten Struktur eine gegenüber den Wandlerstrukturen ganz andere, spezielle Bemessung haben. Die Resonanzfrequenz dieser das Wegtauchen der SBAW-Welle verhindernden Struktur liegt bei angenähert dem 1,25-fachen der Mittenfrequenz der Wandlerstrukturen bzw. des ganzen Filters, d.h. die einzelnen streifenförmigen Belegungen haben vergleichsweise erheblich engere periodische Abstände voneinander. Darin unterscheidet sich eine solche Führungsstruktur z.B. gegenüber einer obenerwähnten und in der EP-A- 0 189 106 im Detail beschriebenen Füllstruktur mit der speziellen Wahl ihrer Frequenz, die der (ersten) Nullstelle der interdigitalen Reflexionen des Filters entspricht. In der Druckschrift ist erwähnt, daß diese für die SBAW- bzw. SSBW-Wellen vorgesehene Struktur auf Masse gelegt ist und abschirmende Wirkung hat.

Eine wie voranstehend beschriebene Führungsstruktur 43 ist bei der Erfindung gemäß den in Figur 4 dargestellten, weiteren Einzelheiten so ausgebildet, daß wieder (wenigstens) zwei Teilstrukturen 4, 45 gebildet sind, die sinngemäß entsprechend den Ausführungsformen insbesondere der Figuren 2 und 3 einzeln mit der jeweils benachbarten Wandlerstruktur 2, 3 verbunden sind, so daß dementsprechend und gemäß der Erfindung die Abschirmung aufgeteilt ist.

Die insbesondere zu den Figuren 2 bis 4 beschriebenen Ausführungsformen der Erfindung betreffen jeweils Fälle mit entweder einer Koppelstruktur (Figur 2), einer Füllstruktur (Figur 3) oder einer Führungsstruktur für SSBW-Wellen (Figur 4). Besonders bei einer Koppelstruktur kann der Fall gegeben sein, daß diese Koppelstruktur entsprechend dem sich aus den Vorgaben dann ergebenden Filterentwurf nur ganz wenige z.B. nur zwei

*) energy trapping grating

oder vier streifenförmige Belegungen hat. Die oben angegebene Aufteilung in zwei Teilstrukturen 24 und 25 würde dann bedeuten, daß eine jeweilige Teilstruktur 24, 25 aus nur zwei oder gar nur noch einer streifenförmigen Belegung besteht. Letzteres würde zwar, was die Anzahl Streifen betrifft, etwa der Ausführungsform nach Figur 1 entsprechen. Bei der Ausführungsform nach Figur 1 sind jedoch die beiden Teilstrukturen 14, 15 solche Belegungen, deren Streifenbreite groß gegenüber der Breite einer solchen streifenförmigen Belegung 123 ist, nämlich deren Breite etwa eine Viertelwellenlänge beträgt. Eine derart schmale streifenförmige Belegung 123 kann eine so geringe elektrische Leitfähigkeit entlang dieser streifenförmigen Belegung haben, daß diese hinsichtlich der geforderten abschirmenden Wirkung entlang dieses Streifens bereits zu großen Reihenwiderstand hat.

Für einen wie voranstehend beschriebenen Fall ist eine weitere Ausführungsform 41 nach Figur 5 anzuwenden, nämlich eine nur wenige, z.B. nur maximal vier streifenförmige Belegungen 123 umfassende Koppelstruktur 24a ungeteilt zu lassen, d.h. als die eine der (wenigstens) zwei Teilstrukturen im Sinne der Erfindung anzuwenden. Als zweite Teilstruktur empfiehlt es sich dann eine solche andere Struktur, z.B. eine Füllstruktur 35a wie nach Figur 3 oder eine Führungsstruktur nach Figur 4 zu verwenden. Eine solche Ausführungsform ist dementsprechend eine Mischung aus dem jeweiligen Prinzip, das einerseits der Figur 2 (mit nur wenigen koppelnden Streifen) und andererseits dem Prinzip der Figur 3 oder 4 entspricht. Die jeweils den hier beschriebenen verschiedenen Prinzipien entsprechenden beiden Teilstrukturen 24a, 35a werden bei der Erfindung so betrieben, daß einerseits die eine Teilstruktur (d.h. die gesamte, nur diese wenigen Koppelstreifen aufweisende Koppelstruktur) mit der einen Wandlerstruktur 2 verbunden und mit dieser auf das Bezugspotential gelegt ist und andererseits eine andere Struktur (Füllstruktur und/oder Führungsstruktur) als zugehörige zweite Teilstruktur 35a vorgesehen und mit der anderen Wandlerstruktur 3 elektrisch verbunden und mit dieser zusammen auf das Bezugspotential gelegt wird. Im Sinne der Erfindung liegt dann wieder eine abschirmende Struktur 53 und zwei Teilstrukturen 24a, 35a vor, die zusammenwirkend gemeinsam die erforderliche abschirmende Wirkung erreichen lassen, obwohl diese beiden Teilstrukturen jede für sich eine voneinander verschiedene Funktion im Filter haben.

## Patentansprüche

1. Mit akustischen Wellen arbeitendes Filter mit elektrischem Eingang und Ausgang

mit einer Anzahl Sammelschienen (6 bis 9) aufweisenden Digitalstrukturen (2, 3), die jeweils streifenförmige, elektrisch leitfähige Belegungen (123) der Oberfläche des Substrats des Filters aufweisen, wobei diese Digitalstrukturen (2, 3) in der Achse (5) der Hauptfortpflanzung der Wellen des Filters angeordnet und die einzelnen Digitalstrukturen Wandlerstrukturen (2, 3) oder Resonatorstrukturen (R1, R2) sind, mit einem Anschluß für ein Bezugspotential (M), wobei je eine der Sammelschienen (7, 8) der Wandlerstrukturen (2, 3) elektrisch mit dem Bezugspotential (M) verbunden ist, und mit zwischen den Digitalstrukturen (2, 3) eines Eingangswandlers und eines Ausgangswandlers angeordneten, abschirmenden Strukturen (14, 15), die elektrisch leitfähige, im wesentlichen quer zur Achse (5) der Hauptfortpflanzung ausgerichtete, streifenförmige Belegungen der Oberfläche des Substrats und die mit dem Anschluß für das Bezugspotental (M) elektrisch verbunden sind, **gekennzeichnet dadurch,** daß wenigstens eine der abschirmenden Strukturen eine Teilstruktur (24, 25; 34, 35; 44, 45; 24a, 35a) ist, die aus einer Anzahl streifenförmiger, nebeneinander angeordneten Belegungen (123) in der Art der Belegungen (123) der Digitalstrukturen (2, 3) besteht, wobei diese Teilstruktur (24, 25; 34, 35; 44, 45; 24a, 35a) mittels einer Verbindungsbelegung (17, 18) mit der mit Bezugspotential (M) verbundenen Sammelschiene (7, 8) derjenigen Wandlerstruktur (2, 3) verbunden ist, die dieser Teilstruktur benachbart angeordnet ist und wobei diese Verbindungsbelegung (17, 18) hinsichtlich ihrer Abmessungen eine Fortsetzung der mit ihr verbundenen Sammelschiene (7, 8) ist.

2. Filter nach Anspruch 1, **gekennzeichnet dadurch,** daß zwei solche Teilstrukturen (24, 25; 34, 35; 44, 45; 24a, 35a) vorgesehen sind, von denen die zu der einen Teilstruktur (24, 34, 44, 24a) gehörige eine Verbindungsbelegung (17) bezogen auf die Achse (5) der Hauptfortpflanzung auf der einen Seite dieser Achse (5) angeordnet ist und die Verbindungsbelegung (18) der anderen Teilstruktur (25, 35, 45, 35a) auf der dazu anderen Seite dieser Achse (5) angeordnet ist.

3. Filter nach Anspruch 1 oder 2, **gekennzeichnet dadurch,** daß die Teilstrukturen (24, 25) zu einer Koppelstruktur (23) des Filters (Fig.2) gehören, wobei diese Koppelstruktur für die akustische Welle reflektierend bemessen ist, und daß die eine Verbindungsbelegung (7) in die eine Sammelschiene der einen Teilstruktur (24) und die andere Verbindungsbelegung (8) in die eine Sammelschiene (8) der anderen Teilstruktur (25) übergeht.

4. Filter nach einem der Ansprüche 1, 2 oder 3, **gekennzeichnet** dadurch, daß die Teilstrukturen (34, 35) zu einem Kollektiv aus weiteren streifenförmigen Belegungen (123) gehören, die einen Zwischenraum zwischen einer Eingangsstruktur und einer Ausgangsstruktur ausfüllen und daß die eine Teilstruktur (34) eine Anzahl dieser weiteren streifenförmigen Belegungen umfaßt, daß die andere Teilstruktur (35) eine weitere Anzahl dieser weiteren streifenförmigen Belegungen umfaßt und diese Teilstrukturen (34, 35) Sammelschienen (27, 28) haben, von denen die jeweils eine Sammelschiene (27, 28) der jeweiligen Teilstruktur (34, 35) in die jeweils zugehörige Verbindungsbelegung (17, 18) übergeht.

5. Filter nach Anspruch 4, **gekennzeichnet** dadurch, daß das diese Teilstrukturen (34, 35) umfaßende Kollektiv aus weiteren streifenförmigen Belegungen (123) eine reflexionsfreie Streifenstruktur ist, wobei die Eigenschaft als reflexionsfrei auf Positionsverschiebungen einzelner Finger bzw. auf gruppenweisen Positionsverschiebungen von Fingergruppen beruht, die jeweils gegenüber vergleichbaren Positionierungen eines Wandlers vorliegen.

6. Filter nach Anspruch 1, oder 2, **gekennzeichnet** dadurch, daß die Teilstrukturen (44, 45) zu einer Führungsstruktur (43) (energy trapping grating) mit weiteren streifenförmigen Belegungen (123) gehören, daß die eine Teilstruktur (44) eine Anzahl dieser weiteren streifenförmigen Belegungen (123) umfaßt, daß die andere Teilstruktur (45) eine weitere Anzahl dieser weiteren streifenförmigen Belegungen (123) umfaßt und diese Teilstrukturen (44, 45) Sammelschienen (27, 28) haben, von denen die jeweils eine Sammelschiene (27, 28) der jeweiligen Teilstruktur (44, 45) in die jeweils zugehörige Verbindungsbelegung (17, 18) übergeht.

7. Filter nach einem der Ansprüche 1 oder 2, **gekennzeichnet** dadurch, daß die eine Teilstruktur (24a) eine Koppelstruktur ist und daß die andere Teilstruktur (35a) eine Füllstruktur oder eine Führungsstruktur ist.

## Claims

1. Filter, operating with acoustic waves, having an electrical input and output, having digital structures (2, 3) having a number of busbars (6 to 9), which structures each have electrically conductive strips (123) on the surface of the substrate of the filter, these digital structures (2, 3) being arranged in the principal propagation axis (5) of the waves of the filter and the individual digital structures being transducer structures (2, 3) or resonator structures (R1, R2), having a terminal for a reference potential (M), in each case one of the busbars (7, 8) of the transducer structures (2, 3) being electrically connected to the reference potential (M), and having shielding structures (14, 15) arranged between the digital structures (2, 3) of an input transducer and an output transducer, which shielding structures are electrically conductive strips on the surface of the substrate which are aligned essentially transversely to the principal propagation axis (5) and are electrically connected to the terminal for the reference potential (M), characterised in that at least one of the shielding structures is a substructure (24, 25; 34, 35; 44, 45; 24a, 35a) which consists of a number of adjacent strips (123) in the manner of the strips (123) of the digital structures (2, 3), this substructure (24, 25; 34, 35; 44, 45; 24a, 35a) being connected by means of a connection strip (17, 18) to the busbar (7, 8), connected to reference potential (M), of that transducer structure (2, 3) which is arranged adjacent to this substructure and this connection strip (17, 18) being, with respect to its dimensions, a continuation of the busbar (7, 8) connected to it.

2. Filter according to Claim 1, characterised in that two such substructures (24, 25; 34, 35; 44, 45; 24a, 35a) are provided of which the one connection strip (17) which is associated with the one substructure (24, 34, 44, 24a) is arranged on the one side of the axis (5) with respect to the principal propagation axis (5) and the connection strip (18) of the other substructure (25, 35, 45, 35a) is arranged on the other side of this axis (5).

3. Filter according to Claim 1 or 2, characterised in that the substructures (24, 25) are part of a coupling structure (23) of the filter (Fig. 2), this coupling structure being dimensioned to be reflective for the acoustic wave, and in that the one connection strip (7) is continuous with the one busbar of the one substructure (24) and the other connection strip (8) is continuous with the one busbar (8) of the other substructure (25).

4. Filter according to one of Claims 1, 2 or 3, characterised in that the substructures (34, 35) are part of a collection of further strips (123) which occupy an intermediate space between an input structure and an output structure, and in that the one substructure (34) comprises a number of these further strips, in that the other substructure (35) comprises a further number of these further strips and these substructures (34, 35) have busbars (27, 28) of which in each case the one busbar (27, 28) of the respective substructure (34, 35) is continuous with the respectively associated connection strip (17, 18).

5. Filter according to Claim 4, characterised in that the collection of further strips (123) comprising these substructures (34, 35) is a reflection-free strip structure, the reflection-free property being due to position shifts of individual fingers or of group position shifts of finger groups which occur in each case with respect to comparable positionings of a transducer.

6. Filter according to Claim 1 or 2, characterised in that the substructures (44, 45) are part of a guide structure (43) (energy trapping grating) having further strips (123), in that the one substructure (44) comprises a number of these further strips (123), in that the other substructure (45) comprises a further number of the further strips (123) and these substructures (44, 45) have busbars (27, 28) of which in each case the one busbar (27, 28) of the respective substructure (44, 45) is continuous with the respectively associated connection strip (17, 18).

7. Filter according to one of Claims 1 or 2, characterised in that the one substructure (24a) is a coupling structure, and in that the other substructure (35a) is a filling structure or a guide structure.

## Revendications

1. Filtre travaillant avec des ondes acoustiques et possédant une entrée et une sortie acoustiques et comportant un certain nombre de structures digitées (2,3), qui possèdent des barres collectrices (6 à 9) et comportent des revêtements électriquement conducteurs respectifs (123) en forme de bandes situés sur la surface du substrat du filtre, ces structures numériques (2,3), situées sur la surface du substrat du filtre, ces structures digitées (2,3) étant disposées sur l'axe (5) de propagation principale des ondes du filtre, les différentes structures digitées étant des structures de transducteurs (2,3) ou des structures de résonateurs (R1,R2), et comportant une borne pour un potentiel de référence (M), auquel est raccordée électriquement respectivement l'une des barres collectrices (7,8) des structures de transducteurs (2,3), et

comportant des structures de protection (14,15), qui sont disposées entre les structures digitées (2,3) d'un transducteur d'entrée et d'un transducteur de sortie, constituent des revêtements en forme de bandes électriquement conductrices, alignés transversalement par rapport à l'axe (5) de propagation principale, sur la surface du substrat et se raccordent électriquement à la borne du potentiel de référence (M),

caractérisé par le fait

qu'au moins l'une des structures de protection est une structure partielle (24,25; 34,35; 44,45; 24a,35a), qui est constituée par un certain nombre de revêtements en forme de bandes (123), disposés côte-à-côte et réalisés à la manière de revêtements (123) de structures digitées (2,3),

cette structure partielle (24,25; 34,35; 44,45; 24a,35a) étant raccordée au moyen d'un revêtement de jonction (17,18) à la barre collectrice (7,8), raccordée au potentiel de référence (M), de la structure de transducteur (2,3), qui est disposée au voisinage de cette structure partielle, et ce revêtement de jonction (17,18) constituant, en rapport avec ses dimensions, un prolongement de la barre collectrice (7,8) raccordée à ce revêtement.

2. Filtre suivant la revendication 1, caractérisé par le fait qu'il est prévu deux telles structures partielles (24,25; 34,35; 44,45; 24a,35a), parmi lesquelles un revêtement de jonction (17) associé à une structure partielle (24,34,44,24a) est disposé, par rapport à l'axe (5) de propagation principale, d'un côté de cet axe (5) et le revêtement de jonction (18) de l'autre structure partielle (25,35,45,35a) est disposé de l'autre côté de cet axe (5).

3. Filtre suivant la revendication 1 ou 2, caractérisé par le fait que les structures partielles (24,25) font partie d'une structure de couplage (23) du filtre (figure 2), cette structure de couplage étant dimensionnée de manière à être réfléchissante pour l'onde acoustique, et qu'un revêtement de jonction (7) se prolonge par une barre collectrice d'une structure partielle (24), tandis que l'autre revêtement de jonction (8) se prolonge par une barre collectrice (8) de l'autre structure partielle (25).

4. Filtre suivant l'une des revendications 1, 2 ou 3, caractérisé par le fait que les structures partielles (34,35) font partie d'un ensemble comprenant d'autres revêtements en forme de bandes (123), qui remplissent un espace intercalaire situé entre une structure d'entrée et une structure de sortie, et

qu'une structure partielle (34) comprend un certain nombre de ces autres revêtements en forme de bandes,

que l'autre structure partielle (35) possède un autre nombre de ces autres revêtements en forme de bandes et que ces structures partielles (34,35) possèdent des barres collectrices (27,28), parmi lesquelles respectivement une barre collectrice (27,28) de la structure partielle respective (34,35) se prolonge par le revêtement de jonction (17,18) respectivement associé.

5. Filtre suivant la revendication 4, caractérisé par le fait que l'ensemble d'autres revêtements en forme de bandes (123), qui comprend ces structures partielles, est une structure en forme de bande non réfléchissante, la caractéristique d'absence de réflexion étant basée sur des décalages des positions de doigts individuels ou des décalages groupés de positions de groupes de doigts, qui sont présents respectivement par rapport à des positionnements comparables d'un transducteur.

6. Filtre suivant la revendication 1 ou 2, caractérisé par le fait

que les structures partielles (44,45) font partie d'une structure de guidage (43) (energy trapping grating) possédant d'autres revêtements en forme de bandes (123),

qu'une structure partielle (44) comprend un certain nombre de ces autres armatures en forme de bandes (123),

que l'autre structure partielle (45) comprend un autre nombre de ces autres revêtements en forme de bandes (123), et

ces structures partielles (44,45) possèdent des barres collectrices (27,28), parmi lesquelles respectivement une barre collectrice (27,28) de la structure partielle respective (44,45) se prolonge par le revêtement de jonction (17,18) respectivement associé.

7. Filtre suivant l'une des revendications 1 ou 2, caractérisé par le fait qu'une structure partielle (24a) est une structure de couplage et que l'autre structure partielle (35a) est une structure de remplissage ou une structure de guidage.

FIG 1

FIG 2

FIG 3

# FIG 4

# FIG 5